# EUROPEAN PATENT SPECIFICATION

(11) **EP 4 546 605 B1**
(45) Date of publication and mention of the grant of the patent: **04.11.2026**
(21) Application number: 24207377.3
(22) Date of filing: 18.10.2024
(51) Int. Cl.: H01M 10/42, H01M 10/48, H01M 50/583, H05K 1/02, H02J 7/70, G01R 31/396

(54) **BATTERY MODULE**
BATTERIEMODUL
MODULE DE BATTERIE

(30) Priority: 26.10.2023 KR 20230145086
(43) Date of publication of application: 30.04.2025
(73) Proprietor: SAMSUNG SDI CO., LTD., Yongin-si, Gyeonggi-do 17084 (KR)
(72) Inventor: Park, Kyunghoon, 17084 Yongin-si, Gyeonggi-do, (KR); Jeong, Hyeongkyu, 17084 Yongin-si, Gyeonggi-do, (KR)
(74) Representative: Gulde & Partner

(56) References cited:
- CN-U- 217 134 519
- US-A1- 2022 085 470

## Description

### BACKGROUND

### 1. Field

One or more embodiments relate to a battery module, with a circuit configuration for measuring a temperature of a plurality of battery cells of a battery module.

### 2. Description of the Related Art

A secondary battery is chargeable and dischargeable, unlike a primary battery that is not chargeable. Low-capacity secondary batteries are used in small portable electronic devices, such as smartphones, feature phones, laptop computers, digital cameras, and camcorders, and high-capacity secondary batteries are used as motor-driving power sources, power-storing batteries, etc., for hybrid vehicles, electric vehicles, etc. A secondary battery may include an electrode assembly including a cathode and an anode, a case accommodating the electrode assembly, an electrode terminal connected to the electrode assembly, etc.

The above-described information disclosed in the technology that serves as the background of the present disclosure is only for improving the understanding of the present disclosure, and may include information that does not constitute the related art.

A battery module includes a plurality of battery cells. The battery module is configured to measure a voltage to identify a state of charge of each of the plurality of battery cells. Examples of an electronic component that measures a voltage of each battery cell may include a wire harness, a flexible printed circuit assembly (FPCA), etc. Conventionally, the wire harness has been used as the electronic component. However, with the increasing number of battery cells in a battery module, it has become difficult to use a structure employing a wire harness due to an excessively large volume of the structure. The FPCA is available as an alternative to the wire harness. However, due to a complicated manufacturing process of the FPCA in comparison to that of the wire harness, the manufacturing cost of the FPCA is high.

US 2022/085470 A1 discloses a battery module in which a main circuit is formed on a rigid printed circuit board (RPCB), while a sensing element including an integrated fuse is implemented on a flexible printed circuit board (FPCB).

CN 217 134 519 U discloses a battery module comprising a cell assembly and a sampling assembly. The cells are connected via connecting pieces, and the housings of the cells are partially used as electrical paths by applying a voltage to them. The sampling and protection circuits are implemented using flexible circuit boards (FPCs) and printed circuit boards.

### SUMMARY

The invention is defined by the appended claims. The description that follows is subjected to this limitation. Any disclosure lying outside the scope of said claims is only intended for illustrative as well as comparative purposes.

One or more embodiments include a battery module which may include an electronic component, in which, by improving a structure of the electronic component, a manufacturing cost of the electronic component may be reduced, and an increase in a volume of the electronic component may be suppressed.

However, aspects of the present disclosure are not limited to the above, and other aspects not mentioned may be clearly understood by those of ordinary skill in the art from the description of the present disclosure described below. Additional aspects will be set forth in part in the description which follows and, in part, will be apparent from the description, or may be learned by practice of the presented embodiments of the present disclosure.

According to one or more embodiments, a battery module includes a voltage measurement circuit electrically connected to battery cells to measure a voltage of the battery cells, the voltage measurement circuit including a main circuit manufactured using a first method, and a fuse electrically connected to the main circuit, and manufactured using a second method that is different from the first method, wherein the first method comprises a flexible die cut, FDC, method.

According to another embodiment, the main circuit may include a conductor part or portion which may be a cut thin metal plate and may be attached to a flexible non-conductive resin plate. This may be the result of the first method. This enables the use of flexible die cut, FDC, methods for the production and application of exclusively physical processes. In other words, the voltage measurement circuit may include a main circuit with a conductor part including cut thin metal plate forming an electric circuit on a flexible non-conductive resin plate, and the fuse electrically connectable to the main circuit. The flexible non-conductive resin plate may also be referred to as FDC film resin.

In the present disclosure, thin may include values in the range of 1 mm to 5 mm.

According to another embodiment, the main circuit may have a structure in which a main circuit pattern is attached to an FDC film resin or flexible non-conductive resin plate. The conductor part may form the main circuit pattern, which in this case is then the electric circuit of the main circuit.

According to another embodiment, a width of the main circuit pattern, or in other words fine pattern, of the main circuit may be at least about 0.3 mm. The main pattern may be an electrical circuit or a part of an electrical circuit of the main circuit. The main circuit pattern may include cut-outs.

According to another embodiment, the first method may include a flexible die cut, FDC, method. According to the FDC method, a conductor part of the main circuit may be manufactured by cutting a thin metal plate using a roller mold, and by attaching the cut metal plate to a flexible non-conductive resin plate.

According to another embodiment, the fuse may include a fuse pattern, or in other words fine pattern, formed and/or attached on an FPC film resin. This may be the result of the second method. In other words, the voltage measurement circuit may include a fuse with a fuse pattern forming an electric circuit on an FPC film resin, and the main circuit electrically connectable to the main circuit.

According to another embodiment, the fuse may be separately provided as a reel-based coupon segment. The reel-based coupon segment means that multiple fuses in form of multiple reel-based coupon segments may be manufactured wound in a roll structure. The reel-based coupon, which may have a roll structure, may be used by unwinding and cutting it into separate segments. The fuse may be configured with a fuse pattern being formed on an FPC film resin.

According to another embodiment, a width of the fuse pattern of the fuse may be about 0.08 mm or less. The fuse pattern may be an electrical circuit or a part of an electrical circuit of the fuse.

According to another embodiment, a width of the main circuit pattern of the main circuit may be greater than a width of the fuse pattern of the fuse.

According to another embodiment, the second method may include a flexible printed circuit, FPC, method.

According to another embodiment, the main circuit and the fuse may be electrically coupled to each other by thermal fusion.

According to another embodiment, the main circuit and the fuse may be electrically connected to each other by a thermal fusible connection.

According to another embodiment, the main circuit and the fuse may be electrically coupled to each other by a surface mounting technology, SMT. An example of a SMT may be coupling based on soldering.

According to another embodiment, the main circuit and the fuse may be electrically connected to each other by a surface mount technology connection.

According to another embodiment, the main circuit and the fuse may be electrically coupled to each other by riveting.

According to another embodiment, the main circuit and the fuse may be electrically connected to each other by a riveted joint.

According to another embodiment, a thickness of the fuse may be less than a thickness of the main circuit.

According to another embodiment, the fuse may be coupled to the main circuit in the form of a patch.

According to one or more embodiments, a method for manufacturing a battery module including a voltage measurement circuit electrically connected to a plurality of battery cells and being configured to measure a voltage of one or more the battery cells, the voltage measurement circuit including a main circuit and a fuse electrically connectable to the main circuit is provided. The method includes the steps of manufacturing the main circuit using a first method, manufacturing the fuse using a second method that is different from the first method and electrically connecting the voltage measurement circuit to the plurality of battery cells, wherein the first method comprises a flexible die cut, FDC, method.

According to another embodiment, the first method may include a flexible die cut, FDC, method.

According to another embodiment, the second method may include a flexible printed circuit, FPC, method.

According to another embodiment, the method further may include electrically coupling the main circuit and the fuse to each other by thermal fusion.

According to another embodiment, the method further may include electrically coupling the main circuit and the fuse to each other by a surface mounting technology, SMT.

According to another embodiment, the method further may include electrically coupling the main circuit and the fuse to each other by riveting.

According to another embodiment, the main circuit may include a main pattern, wherein the main pattern is formed by passing a metal thin plate between an upper roller and a lower roller, which may respectively include uneven patterns on their surfaces.

According to another embodiment, the fuse may be separately provided as a reel-based coupon. The reel-based coupon means that multiple fuses can be manufactured wound in a roll structure. The fuse in form of a reel-based coupon, which has a roll structure, may be used and provided by unwinding and cutting it. The fuse may be configured with a fuse pattern being formed on an FPC film resin. The fuse pattern may be formed by chemical processes, such as masking, development, or etching.

### BRIEF DESCRIPTION OF DRAWINGS

The following drawings attached to this specification illustrate embodiments of the present disclosure, and serve to further understand aspects of the present disclosure together with the detailed description of the present disclosure described later, so the present disclosure should not be construed as being limited to the matters shown in such drawings.

The above and other aspects of certain embodiments of the present disclosure will be more apparent from the following description taken in conjunction with the accompanying drawings, in which:
FIG. 1 schematically shows a configuration of a voltage measurement circuit of a battery module according to one or more embodiments of the present disclosure;
FIG. 2 shows a state in which a fuse of the voltage measurement circuit shown in FIG. 1 is separated from a main circuit of the voltage measurement circuit;
FIG. 3 is a cross-sectional view along the line III - III shown in FIG. 1;
FIG. 4 is a cross-sectional view corresponding to FIG. 3 to show a state before the fuse and the main circuit are coupled to each other; and
FIG. 5 schematically shows a process in which a main circuit pattern is processed using a flexible die cut (FDC) method.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the aspects of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction. Further, the phrase "in a schematic cross-sectional view" means when a schematic cross-section taken by vertically cutting an object portion is viewed from the side.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

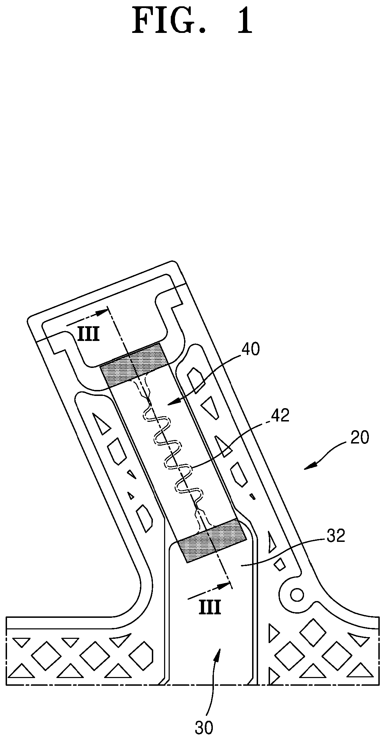

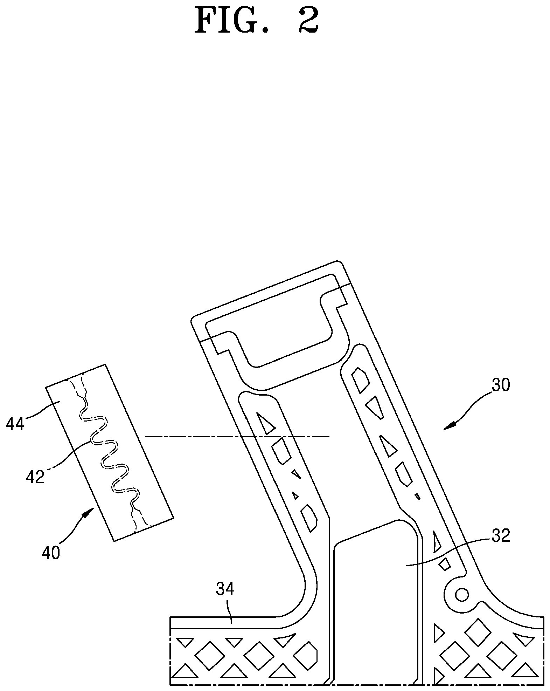

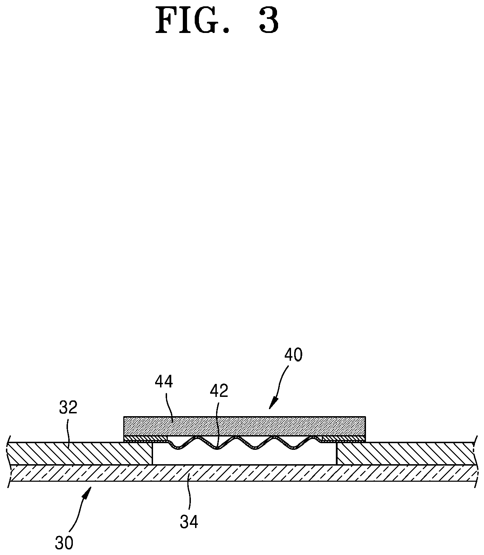

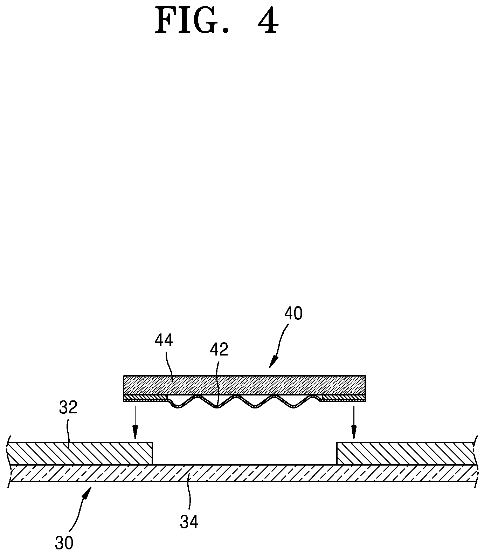

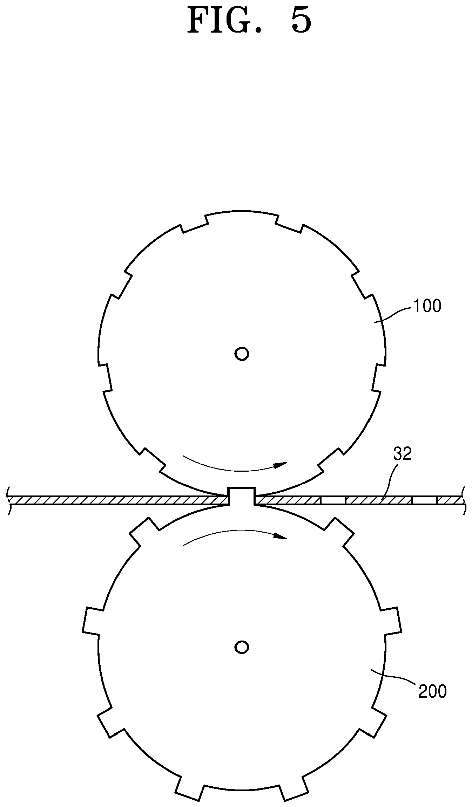

FIG. 1 schematically shows a configuration of a voltage measurement circuit of a battery module according to one or more embodiments of the present disclosure. FIG. 2 shows a state in which a fuse of the voltage measurement circuit shown in FIG. 1 is separated from a main circuit of the voltage measurement circuit. FIG. 3 is a cross-sectional view along the line III - III shown in FIG. 1. FIG. 4 is a cross-sectional view corresponding to FIG. 3 to show a state before the fuse and the main circuit are coupled to each other. FIG. 5 schematically shows a process in which a main circuit pattern is processed using a flexible die cut (FDC) method.

Referring to FIGS. 1 to 5, a battery module according to one or more embodiments of the present disclosure may include a plurality of battery cells, in one or more embodiments. The battery module may include a voltage measurement circuit 20 electrically connected to each of the plurality of battery cells. The voltage measurement circuit 20 may be installed to be coupled to, for example, a cell holder, in one or more embodiments. The voltage measurement circuit 20 may include a main circuit 30 and a fuse 40.

The main circuit 30 may constitute most of the voltage measurement circuit 20. The main circuit 30 may be manufactured using a first method. The first method may be an FDC method. According to the FDC method, a conductor part of a circuit may be manufactured by cutting a thin metal plate using a roller mold, and by attaching the cut metal plate to a flexible non-conductive resin plate. The FDC method may include only physical processes. As a result, the FDC method may not need processes, such as photo-masking, development, etching, etc., unlike a general printed circuit board manufacturing method. As a result, the FDC method may be performed at a cost that is much lower than that of a flexible printed circuit (FPC) method. A width of a fine pattern manufactured using the FDC method may be at least about 0.3 mm. If an electric circuit suitably includes a fine pattern of a width of less than about 0.3 mm, it may be difficult to use the FDC method. The main circuit 30 may have a structure in which a main circuit pattern 32 is attached to an FDC film resin 34 or in other words flexible non-conductive resin plate 34. The main circuit pattern 32 may be formed by being physically cut using a roller mold. FIG. 5 schematically depicts a process in which the main circuit pattern 32 is formed as a metal thin plate passes between an upper roller 100 and a lower roller 200, which may respectively include uneven patterns on their surfaces.

The fuse 40 may be electrically connected to the main circuit 30. The fuse 40 may constitute a safety device for reducing or preventing propagation of fire to a nearby circuit in case of over-current and/or short-circuit in the battery module. The width of the fine pattern of the electric circuit of the fuse 40 may be about 0.08 mm or less. If the width of the fine pattern of the fuse 40 exceeds about 0.08 mm, the fuse 40 may not satisfactorily serve as a fuse. The fuse 40 may be manufactured using a method that is different from the first method. The fuse 40 may be manufactured using a second method that is different from the first method. For example, the fuse 40 may be manufactured using the FPC method. As a chemical process is applied to the FPC method, the width of the fine pattern being about 0.08 mm or less may be implemented. The fuse 40 is more expensive than the main circuit 30 in terms of a manufacturing cost. The fuse 40 may be separately provided as a reel-based coupon. The reel-based coupons mean that multiple fuses can be manufactured wound in a roll structure. The fuse coupon, which has a roll structure, can be used by unwinding and cutting it. The fuse 40 may be configured with a fuse pattern 42 being formed on an FPC film resin 44. The fuse pattern 42 may be formed by chemical processes, such as masking, development, etching, etc., like a general FPC manufacturing method.

The main circuit 30 and the fuse 40 may be electrically coupled to each other by thermal fusion. The main circuit 30 and the fuse 40 may be electrically coupled to each other using a surface mounting technology (SMT). An example of a SMT may be coupling based on soldering. The main circuit 30 and the fuse 40 may be electrically coupled to each other using riveting. The main circuit 30 and the fuse 40 may be electrically coupled to each other using various methods. The fuse 40 may be coupled to the main circuit 30 in the form of a patch.

A thickness of the fuse 40 may be less than that of the main circuit 30. The fuse 40 may be manufactured using the second method (e.g., the FPC method), such that a fine line width of a circuit of the fuse 40, as well as a thickness of the fuse 40, may be respectively less than those of the main circuit 30.

By coupling the main circuit 30 and the fuse 40 of the voltage measurement circuit 20 to each other using different manufacturing methods for them, the voltage measurement circuit 20 may have a hybrid structure. The voltage measurement circuit 20 having the hybrid structure may employ the FPC method providing a high manufacturing cost only for a suitable part, and may apply the FDC method providing a low manufacturing cost and a simple structure, thereby significantly suppressing an increase in a volume of an electronic component if compared to a conventional configuration of an electronic component based on a wire harness. In comparison to a comparative example of a voltage measurement circuit to which the FPC method is applied, the voltage measurement circuit 20 having the hybrid structure may innovatively reduce a manufacturing cost thereof, and may implement a safety function of satisfactorily reducing or preventing fire propagation.

While the present disclosure is described by some embodiments and drawings, the present disclosure is not limited thereby, and various modifications and changes may be made by those of ordinary skill in the art within the present disclosure and the equivalent range to the claims set forth below.

According to the present disclosure, among electronic components for measuring a voltage of a battery cell of the battery module, the main circuit may be manufactured using the first method providing a low manufacturing cost, and the fuse may be manufactured using the second method providing a higher manufacturing cost than the first method, while significantly reducing the manufacturing cost of the main circuit constituting most of the voltage measurement circuit as compared to the main circuit manufactured using the FPCA method, while reducing the manufacturing cost of the electronic component of the battery module, and while maintaining the significantly small volume of the electronic component in comparison to the wire harness.

However, aspects that may be obtained through the present disclosure are not limited to the above-described aspects, and other aspects not mentioned may be clearly understood by those of ordinary skill in the art from the description of the present disclosure described below.

It should be understood that embodiments described herein should be considered in a descriptive sense only and not for purposes of limitation. Descriptions of aspects within each embodiment should typically be considered as available for other similar aspects in other embodiments. While one or more embodiments have been described with reference to the figures, it will be understood by those of ordinary skill in the art that various changes in form and details may be made therein without departing from the scope of the present disclosure as defined by the following claims.

## Claims

1. A battery module comprising a voltage measurement circuit (20) electrically connected to a plurality of battery cells and being configured to measure a voltage of one or more of the battery cells, the voltage measurement circuit (20) comprising:
a main circuit (30) manufactured using a first method; and
a fuse (40) electrically connectable to the main circuit (30), and manufactured using a second method that is different from the first method,
**characterised in that**
the first method comprises a flexible die cut, FDC, method.

2. The battery module as claimed in claim 1, wherein the second method comprises a flexible printed circuit, FPC, method.

3. The battery module as claimed in claim 1 or 2, wherein the main circuit (30) has a structure in which a main circuit pattern (32) is attached to an FDC film resin, and/or wherein the fuse (40) includes a fuse pattern (42) formed on an FPC film resin.

4. The battery module as claimed in any one of claims 1 to 3, wherein the main circuit (30) includes a conductor part and a flexible non-conductive resin plate (34), wherein the conductor part is a cut metal plate forming a main circuit pattern (32) attached to the flexible non-conductive resin plate (34).

5. The battery module as claimed in claim 4, wherein a width of the main circuit pattern (32) of the main circuit (30) may be at least about 0.3 mm and/or wherein a width of the fuse pattern (42) of the fuse (40) may be about 0.08 mm or less.

6. The battery module as claimed in any one of claims 1 to 5, wherein the main circuit (30) and the fuse (40) are electrically coupled to each other by thermal fusion.

7. The battery module as claimed in any one of claims 1 to 5, wherein the main circuit (30) and the fuse (40) are electrically coupled to each other by a surface mounting technology, SMT.

8. The battery module as claimed in any one of claims 1 to 5, wherein the main circuit (30) and the fuse (40) are electrically coupled to each other by riveting.

9. The battery module as claimed in any one of claims 1 to 8, wherein a thickness of the fuse (40) is less than a thickness of the main circuit (30).

10. A method of manufacturing a battery module comprising a voltage measurement circuit (20) electrically connected to a plurality of battery cells and being configured to measure a voltage of one or more of the battery cells, the voltage measurement circuit (20) comprising a main circuit (30) and a fuse (40) electrically connectable to the main circuit (30), the method comprising the steps of:
manufacturing the main circuit (30) using a first method;
manufacturing the fuse (40) using a second method that is different from the first method; and
electrically connecting the voltage measurement circuit (20) to the plurality of battery cells,
wherein the first method comprises a flexible die cut, FDC, method.

11. The method as claimed in claim 10, wherein the second method comprises a flexible printed circuit, FPC, method.

12. The method as claimed in claim 10 or 11, wherein the method further comprises:
electrically coupling the main circuit (30) and the fuse (40) to each other by thermal fusion.

13. The method as claimed in claim 10 or 11, wherein the method further comprises:
electrically coupling the main circuit (30) and the fuse (40) to each other by a surface mounting technology, SMT.

14. The method as claimed in claim 10 or 11, wherein the method further comprises:
electrically coupling the main circuit (30) and the fuse (40) to each other by riveting.

## Patentansprüche

1. Batteriemodul, umfassend eine Spannungsmessschaltung (20), die elektrisch mit einer Vielzahl von Batteriezellen verbunden und dazu konfiguriert ist, eine Spannung einer oder mehrerer der Batteriezellen zu messen, wobei die Spannungsmessschaltung (20) Folgendes umfasst:
eine Hauptschaltung (30), die unter Verwendung eines ersten Verfahrens hergestellt wird, und
eine Sicherung (40), die elektrisch mit der Hauptschaltung (30) verbindbar ist und unter Verwendung eines zweiten Verfahrens hergestellt wird, das sich vom ersten Verfahren unterscheidet,
**dadurch gekennzeichnet, dass**
das erste Verfahren ein Flexible Die Cut-, FDC, -Verfahren umfasst.

2. Batteriemodul nach Anspruch 1, wobei das zweite Verfahren ein Flexible Printed Circuit-, FPC, -Verfahren umfasst.

3. Batteriemodul nach Anspruch 1 oder 2, wobei die Hauptschaltung (30) eine Struktur aufweist, bei der ein Hauptschaltungsmuster (32) auf einem FDC-Filmharz angebracht ist, und/oder wobei die Sicherung (40) ein auf einem FPC-Filmharz ausgebildetes Sicherungsmuster (42) umfasst.

4. Batteriemodul nach einem der Ansprüche 1 bis 3, wobei die Hauptschaltung (30) einen Leiterteil und eine flexible, nichtleitende Harzplatte (34) umfasst, wobei der Leiterteil eine geschnittene Metallplatte ist, die ein Hauptschaltungsmuster (32) bildet, das an der flexiblen, nichtleitenden Harzplatte (34) angebracht ist.

5. Batteriemodul nach Anspruch 4, wobei eine Breite des Hauptschaltungsmusters (32) der Hauptschaltung (30) mindestens etwa 0,3 mm betragen kann, und/oder wobei eine Breite des Sicherungsmusters (42) der Sicherung (40) etwa 0,08 mm oder weniger betragen kann.

6. Batteriemodul nach einem der Ansprüche 1 bis 5, wobei die Hauptschaltung (30) und die Sicherung (40) durch thermische Fusion elektrisch miteinander gekoppelt sind.

7. Batteriemodul nach einem der Ansprüche 1 bis 5, wobei die Hauptschaltung (30) und die Sicherung (40) mittels einer Oberflächenmontagetechnik, SMT, elektrisch miteinander gekoppelt sind.

8. Batteriemodul nach einem der Ansprüche 1 bis 5, wobei die Hauptschaltung (30) und die Sicherung (40) durch Nieten elektrisch miteinander gekoppelt sind.

9. Batteriemodul nach einem der Ansprüche 1 bis 8, wobei eine Dicke der Sicherung (40) geringer ist als eine Dicke der Hauptschaltung (30).

10. Verfahren zur Herstellung eines Batteriemoduls, das eine Spannungsmessschaltung (20) umfasst, die elektrisch mit einer Vielzahl von Batteriezellen verbunden und dazu konfiguriert ist, eine Spannung einer oder mehrerer der Batteriezellen zu messen, wobei die Spannungsmessschaltung (20) eine Hauptschaltung (30) und eine Sicherung (40) umfasst, die elektrisch mit der Hauptschaltung (30) verbindbar ist, wobei das Verfahren die folgenden Schritte umfasst:
Herstellen der Hauptschaltung (30) unter Verwendung eines ersten Verfahrens;
Herstellen der Sicherung (40) unter Verwendung eines zweiten Verfahrens, das sich von dem ersten Verfahren unterscheidet; und
elektrisches Verbinden der Spannungsmessschaltung (20) mit der Vielzahl von Batteriezellen,
wobei das erste Verfahren ein Flexible Die Cut-, FDC, -Verfahren umfasst.

11. Verfahren nach Anspruch 10, wobei das zweite Verfahren ein Flexible Printed Circuit-, FPC, -Verfahren umfasst.

12. Verfahren nach Anspruch 10 oder 11, wobei das Verfahren ferner Folgendes umfasst:
elektrisches Koppeln der Hauptschaltung (30) und der Sicherung (40) miteinander durch thermische Fusion.

13. Verfahren nach Anspruch 10 oder 11, wobei das Verfahren ferner Folgendes umfasst:
elektrisches Koppeln der Hauptschaltung (30) und der Sicherung (40) miteinander mittels einer Oberflächenmontagetechnik, SMT.

14. Verfahren nach Anspruch 10 oder 11, wobei das Verfahren ferner Folgendes umfasst:
elektrisches Koppeln der Hauptschaltung (30) und der Sicherung (40) miteinander durch Nieten.

## Revendications

1. Module de batterie comprenant un circuit de mesure de tension (20) connecté électriquement à une pluralité d'éléments de batterie et étant configuré pour mesurer une tension d'un ou plusieurs des éléments de batterie, le circuit de mesure de tension (20) comprenant:
un circuit principal (30) fabriqué en utilisant un premier procédé; et
un fusible (40) connectable électriquement au circuit principal (30), et fabriqué selon un deuxième procédé différent du premier procédé,
**caractérisé en ce que** le premier procédé comprend un procédé de découpe avec matrice déformable, FDC.

2. Module de batterie selon la revendication 1, dans lequel le deuxième procédé comprend un procédé avec circuit imprimé flexible, FPC.

3. Module de batterie selon la revendication 1 ou la revendication 2, dans lequel le circuit principal (30) présente une structure dans laquelle un motif de circuit principal (32) est fixé à une résine de film de FDC, et/ou dans lequel le fusible (40) comporte un motif de fusible (42) formé sur une résine de film de FPC.

4. Module de batterie selon l'une quelconque des revendications 1 à 3, dans lequel le circuit principal (30) comporte une partie conductrice et une plaque de résine non conductrice flexible (34), dans lequel la partie conductrice est une plaque métallique découpée formant un motif de circuit principal (32) fixée à la plaque de résine non conductrice flexible (34).

5. Module de batterie selon la revendication 4, dans lequel une largeur du motif de circuit principal (32) du circuit principal (30) peut être d'au moins environ 0,3 mm et/ou dans lequel une largeur du motif de fusible (42) du fusible (40) peut être d'environ 0,08 mm ou moins.

6. Module de batterie selon l'une quelconque des revendications 1 à 5, dans lequel le circuit principal (30) et le fusible (40) sont couplés électriquement l'un à l'autre par fusion thermique.

7. Module de batterie selon l'une quelconque des revendications 1 à 5, dans lequel le circuit principal (30) et le fusible (40) sont couplés électriquement l'un à l'autre par une technique de montage en surface, SMT.

8. Module de batterie selon l'une quelconque des revendications 1 à 5, dans lequel le circuit principal (30) et le fusible (40) sont couplés électriquement l'un à l'autre par rivetage.

9. Module de batterie selon l'une quelconque des revendications 1 à 8, dans lequel une épaisseur du fusible (40) est inférieure à une épaisseur du circuit principal (30).

10. Procédé de fabrication d'un module de batterie comprenant un circuit de mesure de tension (20) connecté électriquement à une pluralité d'éléments de batterie et étant configuré pour mesurer une tension d'un ou plusieurs des éléments de batterie, le circuit de mesure de tension (20) comprenant un circuit principal (30) et un fusible (40) apte à être connecté électriquement au circuit principal (30), le procédé comprenant les étapes de:
la fabrication du circuit principal (30) à l'aide d'un premier procédé;
la fabrication du fusible (40) à l'aide d'un deuxième procédé différent du premier procédé; et
la connexion électrique du circuit de mesure de tension (20) à la pluralité d'éléments de batterie,
dans lequel le premier procédé comprend un procédé de découpe avec matrice déformable, FDC.

11. Procédé selon la revendication 10, dans lequel le deuxième procédé comprend un procédé avec circuit imprimé flexible, FPC.

12. Procédé selon la revendication 10 ou 11, dans lequel le procédé comprend en outre:
le couplage électrique entre le circuit principal (30) et le fusible (40) par fusion thermique.

13. Procédé selon la revendication 10 ou 11, dans lequel le procédé comprend en outre:
le couplage électrique du circuit principal (30) et du fusible (40) l'un à l'autre par une technique de montage en surface, SMT.

14. Procédé selon la revendication 10 ou 11, dans lequel le procédé comprend en outre:
le couplage électrique entre le circuit principal (30) et le fusible (40) par rivetage.
